# EUROPEAN PATENT APPLICATION

(11) **EP 2 385 380 A2**
(43) Date of publication of application: **09.11.2011**
(21) Application number: 11163902.7
(22) Date of filing: 27.04.2011
(51) Int. Cl.: G01R 15/18, H01F 29/00, G01R 15/20

(54) **Current detector and method of manufacturing same**

(30) Priority: 28.04.2010 JP 2010103093
(71) Applicant: Tamura Corporation, Tokyo 178-8511 (JP)
(72) Inventor: Kamiyama, Naota, Sakado Saitama 350-0214 (JP); Kobayashi, Masakazu, Sakado Saitama 350-0214 (JP)
(74) Representative: Eisenführ, Speiser & Partner

(57) **Abstract**

The invention relates to a current detector using a magnetic balance system and method of manufacturing same. A plurality of taps N, N-1, N-2, N+1, and N+2 are connected to the output side of the secondary coil, and provided on the winding side of a secondary coil in winding device including a bobbin 120 and PCB 130 at prescribed intervals. The taps respectively correspond to different numbers of turns. Connector sections 200N, 200N-1, 200N-2, 200N+1, and 200N+2 as a tap switching devise is provided. When the tap N is selected to be used, and the connector sections 200N-1, 200N-2, 200N+1, and 200N+2 corresponding to the other taps N-1, N-2, N+1, and N+2 are cut by laser-trimming and electrically disconnected, thereby altering the number of turns of the secondary coil and adjusting the accuracy. Further minute accuracy adjustment is performed by cutting a trimming resistance 203N common to all the taps by laser-trimming.

## Description

### CROSS-REFERENCE TO RELATED APPLICATIONS

This application is based upon and claims the benefit of priority from Japanese Patent Application No. 2010-103093, filed 04/28/2010, which is incorporated herein by reference.

### FIELD OF THE INVENTION

The present invention relates to a current detector using a magnetic balance system which is used for measuring and detecting current, and a method of manufacturing same.

### DESCRIPTION OF THE RELATED ART

A current detector using a magnetic balance system comprises a magnetic core having a gap, a secondary winding wound about the magnetic core, a magnetosensitive element (for example, a Hall element, hereinafter referred as to "Hall element"), and a circuit which amplifies the output current from the Hall element. In this type current detector, a magnetic field produced by the detected current is converged by the magnetic core, and then the magnetic flux is converted into an output voltage by the Hall element which is disposed in the gap of the magnetic core. Such current detector using the magnetic balance system (hereinafter referred as to "magnetic balance type current detector") is used for current measurement in a servo motor, for instance. The current detector detects the current supplied to the motor and the measurement value is fed back to a servo amplifier and is used as one of control parameters.

In the magnetic balance type current detector, the secondary winding around the magnetic core is wound in a direction in which the magnetic field produced by the measured current is canceled out. When the measured current is flowing, an output voltage is produced in the Hall element due to the magnetic field corresponding to the measured current, and a voltage signal output from this Hall element is converted into a current by a current amplification circuit and is fed back to the secondary winding. The magnetic field produced by the secondary winding (canceling magnetic field) and the magnetic field produced by the measured current cancel each other, in such a manner that the magnetic field in the gap is zero at all times. A canceling current flowing in the secondary winding is passed through an output resistor and converted into a voltage, which is extracted as an output (see Japanese Patent Application Laid-open No. 2007-147460).

As described above, the magnetic balance type current detector has a composition in which the magnetic field produced by the measured current is canceled by the magnetic field produced by the secondary coil, and this type current detector corresponds to a closed-loop type current detector operating such that the magnetic flux in the core is zero at all times.

Output accuracy of the current detector is affected by various error-causing factors, such as error in the number of windings, position of the Hall element arranged in the gap of the core, position of the secondary coil, position of the conductor carrying the measured current, finishing of the end faces defining the core gap, and the like. It is extremely difficult to manufacture a current detector which can control all of these error-causing factors and thus achieve a high accuracy.

For example, in the conventional magnetic balance type current detector as described above, the intensity of the canceling magnetic field around the Hall element varies depending on the position of the Hall element disposed in the core gap, in other words, depending on the positional relationship between the core with the secondary winding therearound and the Hall element. Therefore, the current detection accuracy is greatly affected by the accuracy of these assembled positions. The other factors described above also affect the current detection accuracy, and therefore it is difficult to adjust the accuracy in each individual product. Consequently, it has been extremely difficult to improve product yield by controlling and eliminating the errors caused by all of the factors in a unified manner. As a measure for resolving this problem, it has been desired to develop a technique for adjusting errors caused by various factors in a subsequent step, thereby achieving high accuracy in current detection in a current detector.

### SUMMARY OF THE INVENTION

The present invention was made in view of these problems. It is an object of the present invention to provide a magnetic balance type current detector capable of achieving high accuracy in current detection.

A further object of the present invention is to provide a method of manufacturing a current detector having high accuracy in current detection in which errors caused by various factors are adjusted in a subsequent step.

The present inventors thoroughly studied the above described problems. As a result, it was proposed a composition and a manufacturing method of a magnetic balance type current detector in which the degree of freedom of setting the number of turns in a secondary coil (secondary winding) can be achieved by switching a winding tap, and thus errors in current detection accuracy caused by various factors can be adjusted in the subsequent step. The inventors found out that, according to this composition and manufacturing method, improved accuracy can be achieved by switching a winding tap, and it has a very significant effect in enhancing the adjustment accuracy of the current detector and in improving product yield.

According to the present invention, it is possible to obtain a current detector including at least a core, a secondary coil wound in a prescribed number of turns about the core via a winding device, and a magnetosensitive element disposed in a gap formed by the core, the current detector comprising: a plurality of taps, which are connected to an output side of the secondary coil, and provided on a winding side of the secondary coil in the winding device at prescribed intervals such that the plurality of taps respectively correspond to different numbers of turns of the coil; and a tap switching device which switches a tap to be used by selecting a desired tap among the plurality of taps.

Furthermore, desirably, the plurality of taps are connected via a resistance element having a prescribed resistance value, and comprises an activation/deactivation device which electrically activates or deactivates the resistance element.

Moreover, according to the present invention, it is possible to obtain a method of manufacturing a current detector including at least a core, a secondary coil wound in a prescribed number of turns about the core via a prescribed winding device, and a magnetosensitive element disposed in a gap formed by the core, the current detector being provided with a plurality of taps, which are connected to an output side of the secondary coil and are provided on a winding side of the secondary coil in the winding device at prescribed intervals such that the plurality of taps respectively correspond to different numbers of turns of the coil, and a tap switching device which switches a tap to be used by selecting a desired tap among the plurality of taps, the method comprising at least a step of switching the tap to be used by the tap switching device as a subsequent step to at least a step of disposing the magnetosensitive element in the gap of the core.

Furthermore, desirably, the plurality of taps are connected via a resistance element having a prescribed resistance value, and in addition to the step of switching the tap to be used, the method further comprising a step of electrically activating or deactivating the resistance element.

According to the present invention, it is possible to provide a current detector using a magnetic balance system and a method of manufacturing same in which the degree of freedom of setting the number of turns in a secondary coil (secondary winding) can be achieved by switching a winding tap, and thus errors in current detection accuracy caused by various factors can be adjusted in a subsequent step.

### BRIEF DESCRIPTION OF THE DRAWINGS

Fig. 1 is a block diagram showing a control system of a servo motor which uses a current detector according to an embodiment of the present invention, together with a controlled motor;
Fig. 2 is a diagram for explaining an operating principle of the current detector according to the embodiment of the present invention;
Fig. 3 is a diagram showing a bobbin about which a secondary coil (secondary winding) is wound, and winding taps provided on the bobbin, in the current detector according to the embodiment of the present invention;
Fig. 4 is a diagram showing a winding tap section of a printed circuit board (PCB), which is a part of a composition in Example 1 aimed at achieving improved accuracy by switching the winding taps in the current detector according to the embodiment of the present invention, and illustrates an example of a laser-trimming of a PCB pattern;
Fig. 5 is a diagram showing a winding tap section of a PCB, which is a part of a composition in Example 2 aimed at achieving improved accuracy by switching winding taps in combination with a trimming resistance in a current detector according to the embodiment of the present invention, and illustrates an example of the laser-trimming of the PCB pattern together with a trimming by disposing the resistance;
Fig. 6 is a diagram showing a winding tap section of a PCB, which is a part of the composition of Example 3 aimed at achieving a multi-range method by switching winding taps, in the current detector according to the embodiment of the present invention, and illustrates an example of the laser-trimming of the PCB pattern together with an accuracy adjustment by trimming of the resistance.

### DESCRIPTION OF THE PREFERRED EMBODIMENTS

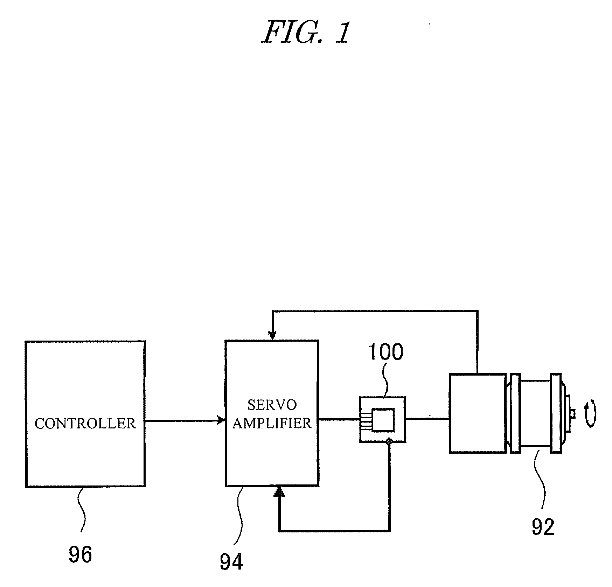

The current detector according to an embodiment of the present invention is described in detail with reference to the drawings. The current detector according to the present embodiment, that is, the magnetic balance type current detector is used for current measurement in a servo motor, for example. Fig. 1 is a block diagram showing a control system of a servo motor in which a current detector 100 according to the present embodiment is used, together with the controlled motor.

The control system for the servo motor shown in Fig. 1 comprises a controlled motor 92, a servo amplifier 94, a controller 96 and a magnetic balance type current detector 100. The current detector 100 measures a current flowing to the controlled motor 92, and the measurement value thereof is fed back to the servo amplifier 94 and is used as one of control parameters of the controller 96.

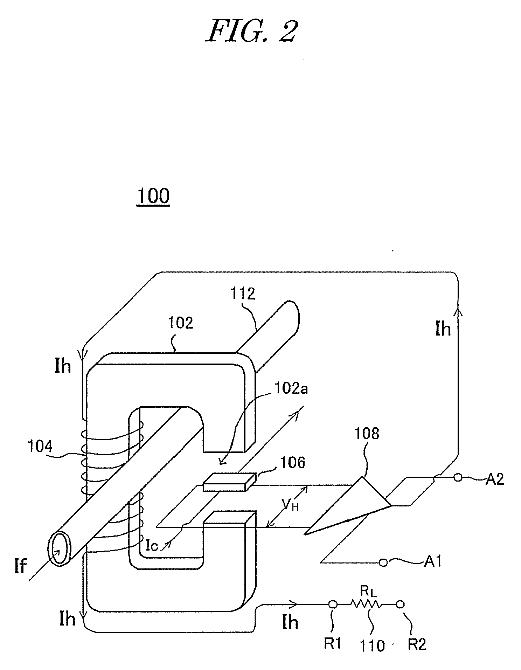

Fig. 2 is a diagram for explaining the operating principle of the magnetic balance type current detector 100 according to the present embodiment. As shown in Fig. 2, the magnetic balance type current detector 100 comprises a core 102 consisting of a substantially annular magnetic body having a gap, a secondary winding 104 winding about the core 102, a Hall element 106 as a magnetosensitive element disposed in a gap portion 102a of the core 102, and a current amplification circuit 108 amplifying the Hall voltage Vh of the Hall element 106 as well as converting the amplified voltage to a current Ih. One end of the secondary winding 104 is connected to the current amplification circuit 108 and the other end thereof is earthed via a load resistor 110. A current wire 112 is disposed in a space surrounded by the core 102 in a direction perpendicular to the central axis of the core 102. On the other hand, the secondary winding 104 described above is wound about in a direction in which magnetic field produced by the secondary winding eliminates a magnetic field produced by the detected current If flowing in the current wire 112. In addition to the winding direction of the secondary winding 104, for example, the amplification rate of the current amplification circuit 108 is also set in such a manner that the magnetic field produced in the core 102 due to the detected current If flowing in the current wire 112 and the magnetic field produced in the core 102 due to the current Ih flowing in the secondary winding 104 cancel each other out.

In the magnetic balance type current detector 100 having the composition described above, the Hall voltage Vh generated in the Hall element 106 corresponding to the detected current If is firstly converted into a current Ih through the current amplification circuit 108, and then outputted to the secondary winding 104 as feedback. When the current Ih flows in the secondary winding 104 as described above, a balanced state is created since the magnetic field based on the detected current If is canceled by "the canceling magnetic field", that is, the magnetic field based on the current Ih (generated by the secondary winding 104). More specifically, the detector operates in such a manner that the magnetic field based on the detected current If and the canceling magnetic field cancel each other out, and thus the magnetic field in the gap portion 102a becomes zero at all times. In this case, the voltage drop in the load resistor 110 is detected as a sensor output voltage between the terminals R1 and R2. By detecting the current Ih based on this sensor output voltage, it is possible to detect the detected current If flowing in the current wire 112. A DC power source (not illustrated) is connected between the terminals A1 and A2 of the current amplification circuit 108. Furthermore, Ic denotes a drive current of the Hall element 106.

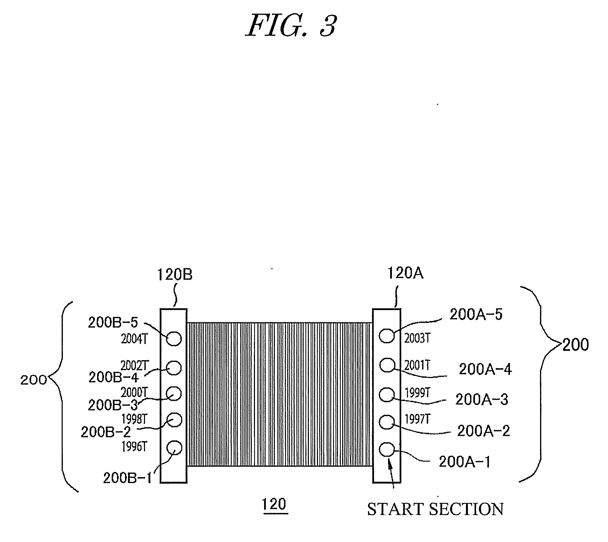

According to the magnetic balance type current detector 100 of this kind, temperature drift caused by temperature dependence of the Hall element 106 is suitably restricted, and good linearity between the detected current If and the sensor output voltage VH is obtained, therefore the detected current If can be detected with high accuracy. In order to manufacture the above-described magnetic balance type current detector 100, it is necessary to wind the secondary coil (secondary winding) about a bobbin. However, as stated previously, the number of windings of the secondary coil affects the magnitude of the canceling current, and therefore a variation in characteristics is produced due to variation in the number of windings. For solving this problem, the present inventors prepared winding taps as shown in Fig. 3. Here, the present embodiment is explained by using a current detector 100 having a secondary winding of 2000 turns as an example.

Fig. 3 is a diagram showing a bobbin about which a secondary coil (secondary winding) of the current detector 100 is wound, and winding taps provided on the bobbin. As shown in Fig. 3, a bobbin 120 for winding the secondary coil (secondary winding) of the current detector 100 thereon has flange portions 120A and 120B. A plurality of taps 200 are respectively disposed on each flange portions 120A and 120B at equal intervals. Taps 200A-1, 200A-2, 200A-3, 200A-4 and 200A-5 are disposed on the flange portion 120A. Taps 200B-1, 200B-2, 200B-3, 200B-4 and 200B-5 are disposed on the flange portion 120B. among these taps, the tap 200A-1, for example, corresponds to a winding start section, and the other taps 200B-1, 200A-2, 200B-2, 200A-3, 200B-3, 200A-4, 200B-4, 200A-5 and 200B-5 respectively correspond to 1996 turns, 1997 turns, 1998 turns, 1999 turns, 2000 turns, 2001 turns, 2002 turns, 2003 turns and 2004 turns of the winding.

Accordingly, when using the current detector 100 having the secondary winding of 2000 turns, the output control can be theoretically realized within ±0.025% by preparing winding taps in one turn increments. Consequently, for example, when the current detector 100 is required to have a normal accuracy within ±0.25%, then the defective product rate can be reduced close to zero, and the product yield is improved distinctively. Moreover, high accuracy can also be guaranteed.

### [Example 1]

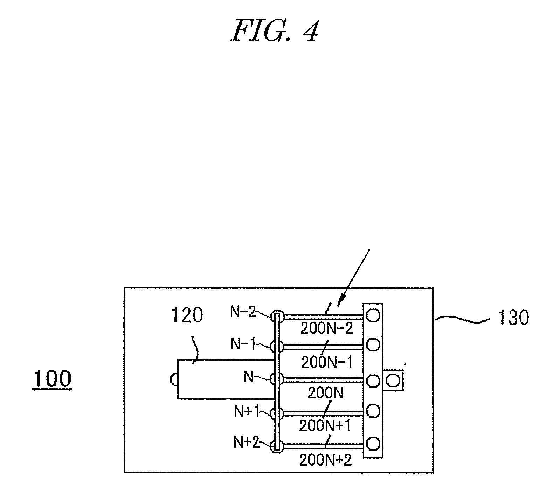

Fig. 4 is a diagram showing a winding tap section of a printed circuit board (PCB), which is a part of a composition in Example 1 aimed at achieving improved accuracy by switching the winding taps in the current detector 100 according to the embodiment of the present invention, and illustrates an example of a laser-trimming of a PCB pattern. Specifically, in the current detector 100 of this example, a secondary coil (secondary winding) is formed on the bobbin 120, and the terminal sections and the connector sections of the winding taps are formed as the pattern of the PCB 130, in such a manner that the unnecessary taps are cut with a trimmer (using laser-trimming). In Example 1 shown in Fig. 4, in order to activate a tap N (at N^{th} turn; 2000^{th} turn when there are 2000 turns), while deactivating a tap N-1 (at N-1^{st} turn; the 1999^{th} turn of 2000 turns), a tap N-2 (at N-2^{nd} turn; the 1998^{th} turn of 2000 turns), a tap N+1 (at N+1^{st} turn; the 2001^{st} turn of 2000 turns), and a tap N+2 (at N+2^{nd} turn; the 2002^{nd} turn of 2000 turns), the corresponding connector sections 200N-1, 200N-2, 200N+1 and 200N+2 are cut with a trimmer (using laser-trimming), so as to be electrically disconnected.

In this way, the tap section as shown in Fig. 4 is formed in advance as a pattern of the PCB 130, and then, as a result of accuracy adjustment, connector sections of the unnecessary taps are cut with a trimmer (using laser-trimming). By this way, the accuracy deviation due to the various error-causing factors described above can be adjusted and corrected for in the wire-connecting step of the secondary coil (secondary winding).

### [Example 2]

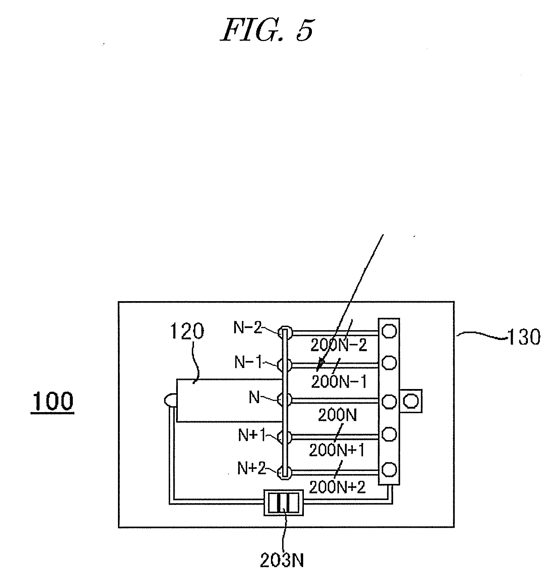

Fig. 5 is a diagram showing a winding tap section of a PCB 130, which is a part of a composition in Example 2 aimed at achieving improved accuracy by switching winding taps in combination with a trimming resistance in a current detector 100 according to the embodiment of the present invention, and illustrates an example of the laser-trimming of the pattern of the PCB 130 together with a trimming by disposing the resistance. Specifically, in the current detector 100 of Example 2, a secondary coil (secondary winding) is formed on the bobbin 120, the terminal sections and the connector sections of the winding taps are formed as the pattern of the PCB 130, and in particular, a trimming resistance common thereto is provided between these taps and the input side. Similar to Example 1, unnecessary taps are cut with a trimmer (using laser-trimming). Furthermore, with respect to the activated tap, further adjustment accuracy of the current detection can be achieved by cutting the trimming resistance if necessary. As shown in Fig. 5, in Example 2, a common trimming resistance 203N is provided between the input side and the taps N, N-1, N-2, N+1, and N+2. Firstly, in order to activate the tap N (at N^{th} turn; the 2000^{th} turn when there are 2000 turns), while deactivating the tap N-1 (at N-1^{st} turn; the 1999^{th} turn of 2000 turns), the tap N-2 (at N-2^{nd} turn; the 1998^{th} turn of 2000 turns), the tap N+1 (at N+1^{st} turn; the 2001^{st} turn of 2000 turns) and the N+2 tap (at N+2^{nd} turn; the 2002^{nd} turn of 2000 turns), the connector sections 200N-1, 200N-2, 200N+1 and 200N+2 are cut with a trimmer (using laser-trimming), so as to be electrically disconnected. Furthermore, with respect to the activated tap, the resistance can be adjusted by cutting the common trimming resistance 203N. Consequently, adjustment accuracy of the current detection can be enhanced further. As described above, the tap section shown in Fig. 5 is formed in advance as the pattern of the PCB 130, and the common trimming resistance is arranged between the input side and the taps N, N-1, N-2, N+1, and N+2, the connector sections of the unnecessary taps are cut with a trimmer (using laser-trimming) in order to deactivate them. Also with respect to the activated tap, further accuracy adjustment can be made, if necessary, by cutting the common trimming resistance. By this way, enhanced current detection accuracy can be achieved.

### [Example 3]

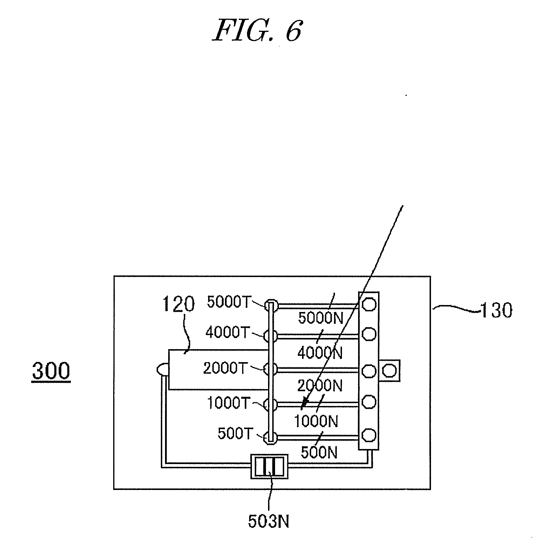

Fig. 6 is a diagram showing a winding tap section of a PCB 130, which is a part of the composition of Example 3 aimed at achieving a multi-range method by switching winding taps, in a current detector 300 according to the embodiment of the present invention, and illustrates an example of the laser-trimming of the pattern of the PCB 130 together with an accuracy adjustment by trimming of the resistance. Specifically, the current detector 300 in Example 3 uses a multi-range system where the number of turns of the secondary winding can be varied, in contrast to the current detectors 100 of Examples 1 and 2 which have the secondary winding of 2000 turns.

Specifically, in the current detector 300 of Example 3, a secondary coil (secondary winding) is formed on the bobbin 120, the terminal sections and connector sections in the winding taps are formed as the pattern of the PCB 130, and in particular, a trimming resistance common thereto is provided between these taps and the input side. By cutting unnecessary taps with a trimmer (using laser-trimming), it is possible to select the number of turns of the secondary winding. Furthermore, if necessary, accuracy adjustment is performed by cutting the common trimming resistance.

As shown in Fig. 6, in Example 3, a common trimming resistance 503N is arranged between the input side and taps 500T, 1000T, 2000T, 4000T, and 5000T. When 2000 turns is selected as the number of turns of the secondary winding, firstly in order to activate the tap 2000T at 2000 turns while deactivating the taps 500T, 1000T, 4000T, and 5000T respectively at 500, 1000, 4000, and 5000 turns, their corresponding connector sections 500N, 1000N, 4000N, and 5000N are cut with a trimmer (using laser-trimming) so as to be electrically disconnected. In addition, when accuracy adjustment is needed, the common trimming resistance 503N is cut, so as to adjust the current detection accuracy with respect to the activated tap 2000T.

As described above, the tap section shown in Fig. 6 is formed in advance as the pattern of the PCB 130, and the common trimming resistance is arranged between the input side and the taps 500T, 1000T, 2000T, 4000T, and 5000T, the connector sections of the unnecessary taps are cut with a trimmer (using laser-trimming) in order to deactivate them. In addition, with respect to the activated tap, accuracy adjustment is performed by cutting the common trimming resistance, if necessary. Accordingly, it is possible to adjust the current detection accuracy, as well as select the number of turns of the secondary winding.

The present invention, which is a magnetic balance type current detector in which a secondary coil (secondary winding) is wound about a bobbin, etc., is not limited to a current detector using a Hall element as a magnetosensitive element. It may also be applied widely to the other current detectors, such as a detector using an MR element, provided that taps can be formed on a bobbin or a substrate.

In the above-described Examples, the current detector according to the present invention is used in a servo motor control system, but of course can be used widely in other applications.

Furthermore, in the above-described Examples, a square-shaped core is used, but of course the present invention can also be applied to a current detector using a core of another shape, for example, an elliptical core, a circular ring core, or the like.

Moreover, in the above-described Examples, a common trimming resistance is provided between the input side and the plurality of taps, and accuracy adjustment of the activated tap is performed by cutting the common trimming resistance, if necessary. However, it is also possible to provide trimming resistances for each of the connector sections of the plurality of taps, for example at an intermediate portion thereof. In this case, accuracy adjustment is performed by cutting the trimming resistance of the activated tap, if necessary.

Furthermore, in the present invention, "electrically activating or deactivating a resistance" also includes a case in which a resistance wire disconnected at first is connected to be activated. "Activating or deactivating the resistance" may include disconnection of a wire which is initially connected and connection of a wire which is initially disconnected, and moreover, the resistance may not be a wire and may be a metal plate having a prescribed resistance value, which is not a commercial resistor. All of these meanings are included. Furthermore, the term "resistance" includes any of electrical resistances, therefore it includes a variable resistance, of course. When a variable resistance is used, the varied (set) resistance value is to be activated or deactivated.

## Claims

1. A current detector including at least a core, a secondary coil wound in a prescribed number of turns about the core via a winding device, and a magnetosensitive element disposed in a gap formed by the core, the current detector comprising:
a plurality of taps, which are connected to an output side of the secondary coil, and provided on a winding side of the secondary coil in the winding device at prescribed intervals such that the plurality of taps respectively correspond to different numbers of turns of the coil; and
a tap switching device which switches a tap to be used by selecting a desired tap among the plurality of taps.

2. The current detector according to claim 1, wherein the plurality of taps are connected via a resistance element having a prescribed resistance value, and comprises an activation/deactivation device which electrically activates or deactivates the resistance element.

3. A method of manufacturing a current detector including at least a core, a secondary coil wound in a prescribed number of turns about the core via a prescribed winding device, and a magnetosensitive element disposed in a gap formed by the core,
the current detector being provided with a plurality of taps, which are connected to an output side of the secondary coil and are provided on a winding side of the secondary coil in the winding device at prescribed intervals such that the plurality of taps respectively correspond to different numbers of turns of the coil, and a tap switching device which switches a tap to be used by selecting a desired tap among the plurality of taps,
the method comprising at least a step of switching the tap to be used by the tap switching device as a subsequent step to at least a step of disposing the magnetosensitive element in the gap of the core.

4. The method of manufacturing a current detector according to claim 3, wherein the plurality of taps are connected via a resistance element having a prescribed resistance value, and in addition to the step of switching the tap to be used, the method further comprising a step of electrically activating or deactivating the resistance element.
